# EUROPÄISCHE PATENTSCHRIFT

(11) **EP 1 398 511 B1**
(45) Veröffentlichungstag und Bekanntmachung des Hinweises auf die Patenterteilung: **04.12.2013**
(21) Anmeldenummer: 03019804.8
(22) Anmeldetag: 30.08.2003
(51) Int. Cl.: F04D 29/58, G06F 1/20, H01L 23/473

(54) **Vorrichtung zur lokalen Kühlung oder Erwärmung eines Gegenstandes**
Local cooling system
Système de refroidissement local

(30) Priorität: 13.09.2002 DE 10243026
(43) Veröffentlichungstag der Anmeldung: 17.03.2004
(73) Patentinhaber: Xylem IP Holdings LLC, White Plains, NY 10604 (US)
(72) Erfinder: Laing, Oliver, 70435 Stuttgart (DE)
(74) Vertreter: Hoeger, Stellrecht & Partner Patentanwälte

(56) Entgegenhaltungen:
- EP-A- 1 085 217
- WO-A-03/098415
- US-A- 6 019 165
- US-A- 6 132 184
- US-B1- 6 327 145

## Beschreibung

Die Erfindung betrifft eine Vorrichtung zur lokalen Kühlung oder Erwärmung eines Gegenstandes mittels einer Flüssigkeit, umfassend eine Umwälzpumpe für die Flüssigkeit, wobei ein thermisches Kontaktelement für die thermische Kontaktierung des Gegenstandes in die Umwälzpumpe integriert ist und Flüssigkeit an dem thermischen Kontaktelement vorbeigeführt wird.

Vorrichtungen zur lokalen Kühlung oder Erwärmung eines Gegenstandes mittels einer Flüssigkeit, umfassend eine Umwälzpumpe für die Flüssigkeit, werden beispielsweise zur Flüssigkeitskühlung von Mikroprozessoren eingesetzt.

In der US 6,327,145 B1 ist eine Wärmeabführungsvorrichtung beschrieben, welche einen Basisbereich mit einer darin definierten Kammer umfasst. Eine Mehrzahl von Projektionen erstreckt sich von diesem Basisbereich weg. Weiterhin ist eine Pumpe in der Kammer angeordnet und mindestens eine Zirkulationsröhre steht in wirksamer Verbindung mit der Pumpe und erstreckt sich von der Kammer weg, um mindestens eine der Mehrzahl von Projektionen zu kontaktieren.

Der Erfindung liegt die Aufgabe zugrunde, eine gattungsgemäße Vorrichtung zu schaffen, welche einfach aufgebaut ist.

Diese Aufgabe wird bei der eingangs genannten Vorrichtung erfindungsgemäß dadurch gelöst, daß das thermische Kontaktelement Teil eines Gehäuses der Umwälzpumpe ist und daß das thermische Kontaktelement flexibel ausgebildet ist und/oder beweglich an dem Gehäuse der Umwälzpumpe gelagert ist.

Gemäß der erfindungsgemäßen Lösung ist damit der Kühlkörper bzw. Heizkörper, welcher mit dem Gegenstand in Kontakt gebracht wird, ein Teil der Umwälzpumpe. Dadurch läßt sich ein kompakter Aufbau einer Flüssigkeits-Kühlungsvorrichtung bzw. Flüssigkeits-Heizvorrichtung mit effektiver Kühlung oder Heizung des kontaktierten Gegenstandes erreichen.

Weiterhin läßt sich ein hoher Wirkungsgrad bezüglich der Kühlung bzw. der Heizung erreichen, da die Flüssigkeit vor Beaufschlagung des thermischen Kontaktelementes beschleunigt wird und sich über die entstehende Strömung ein guter thermischer Kontakt zu dem thermischen Kontaktelement erreichen läßt. Es läßt sich dann Wärme optimal abführen bzw. Wärme optimal zuführen. Es läßt sich auch über die Umwälzpumpe eine für die Wärmeabfuhr bzw. Wärmezufuhr optimale Strömungsform einstellen.

Über entsprechende Ausbildung des thermischen Kontaktelements insbesondere angepaßt an eine Kontaktoberfläche des Gegenstandes läßt sich bei minimierten Abmessungen eine gute Kühlungsfunktion bzw. Heizfunktion erreichen.

Das thermische Kontaktelement ist Teil eines Gehäuses der Umwälzpumpe. Dadurch läßt sich die Vorrichtung auf einfache Weise herstellen. Weiterhin läßt sich so bei entsprechende Positionierung der Umwälzpumpe eine Kühlfunktion bzw. Erwärmungsfunktion bezüglich des Gegenstandes erreichen: Die Umwälzpumpe wird mit dem thermischen Kontaktelement an den Gegenstand angelegt und bezüglich diesem fixiert, beispielsweise über Klammern oder formschlüssige Verbindungen.

Das thermische Kontaktelement ist flexibel ausgebildet und/oder beweglich an einem Gehäuse der Umwälzpumpe gelagert ist. Beispielsweise ist dann das thermische Kontaktelement als flexible Platte ausgebildet, die aber noch genügend Eigensteifigkeit aufweist. Dadurch ist ein Ausdehnungsvolumen für die Flüssigkeit nach Erwärmung bereitstellbar und es läßt sich ein Vordruck auf das System ausüben.

Es kann auch vorgesehen sein, daß das thermische Kontaktelement eine dünne Membran ist, die sich an den Gegenstand anlegt oder von einem Faltenbalg umfaßt ist.

Insbesondere ist es vorgesehen, daß das thermische Kontaktelement einen Gehäusedeckel der Umwälzpumpe bildet, so daß das thermische Kontaktelement kein zusätzliches Bauteil darstellt und die Umwälzpumpe und damit auch die Vorrichtung auf einfache Weise herstellbar ist.

Insbesondere begrenzt dabei das thermische Kontaktelement einen Drallraum der Umwälzpumpe. In dem Drallraum wird in der Flüssigkeit ein Drall erzeugt und am Ausgang in einem spiralförmigen Pumpengehäuse in Druck zur Umwälzung der Flüssigkeit umgesetzt. Wenn das thermische Kontaktelement den Drallraum begrenzt, dann läßt sich eine optimale Wärmeankopplung zwischen Flüssigkeit und thermischem Kontaktelement erreichen und damit wiederum eine optimale Wärmeabfuhr bzw. Wärmezufuhr zu dem Gegenstand.

Insbesondere ist in dem Drallraum ein Laufrad (Schaufelrad) rotierbar, welches beispielsweise als Teil eines Elektromotors angetrieben ist, und über das sich in der Flüssigkeit ein Drall erzeugen läßt.

Es kann auch vorgesehen sein, daß die Umwälzpumpe eine Deckplatte, insbesondere in der Form einer Deckscheibe für das Schaufelrad aufweist. Eine Deckplatte erhöht üblicherweise die Pumpleistung, während ohne Deckplatte die Strömungsgeschwindigkeit höher ist. Durch Verwendung einer Deckplatte bzw. Weglassen einer solchen lassen sich für die spezielle Anwendung die optimalen Bedingungen einstellen.

Ganz besonders vorteilhaft ist es, wenn eine Durchsatzströmung, welche mittels des Schaufelrads erzeugt ist, an dem thermischen Kontaktelement vorbeigeführt ist. Dadurch läßt sich eine optimale Wärmeankopplung zwischen Umwälzpumpe und dem Gegenstand erreichen, so daß hier wiederum eine optimale Kühlung bzw. Erhitzung erreichbar ist.

Wenn das Schaufelrad dem thermischen Kontaktelement zugewandt angeordnet ist, läßt sich eine optimierte Strömungsführung ausbilden, um Wärme von dem thermischen Kontaktelement abzuführen bzw. Wärme diesem zuzuführen.

Bei einer Variante eines Ausführungsbeispiels ist das thermische Kontaktelement aus einem metallischen Material wie Kupfer hergestellt, um so eine hohe Wärmeleitfähigkeit zu erreichen, um so wiederum optimal Wärme von einem Gegenstand abführen zu können bzw. diesem zuführen zu können.

Wenn das thermische Kontaktelement als Platte ausgebildet ist, welche insbesondere eine konstante Höhe aufweist, dann lassen sich Wärmespitzen in dem thermischen Kontaktelement vermeiden.

Grundsätzlich ist es möglich, daß die Umwälzpumpe einen Elektromotor wie einen Zylindermotor, einen Scheibenmotor, einen Außenläufermotor umfaßt oder sie kann über eine permanentmagnetische Kupplung angetrieben sein.

Ganz besonders vorteilhaft ist es jedoch, wenn die Umwälzpumpe als Kreiselpumpe ausgebildet ist mit einem sphärischen Elektromotor. Es läßt sich dann eine spielfreie Lagerung eines Rotors erreichen, so daß zum einen eine hohe Lebensdauer und damit hohe Zuverlässigkeit der Umwälzpumpe erreicht ist.

Zum anderen ist bei einer sphärischen Lagerung die Geräuschbildung minimiert, so daß eben nur geringe Betriebsgeräusche vorhanden sind. Weiterhin läßt sich die Bauhöhe (parallel zur Drehachse des Rotors) bei einer Kreiselpumpe minimieren.

Insbesondere ist ein sphärisches Lager für einen Rotor der Umwälzpumpe vorgesehen, um so eine spielfreie Lagerung mit Minimierung der Bauhöhe zu erhalten.

Weiterhin ist es günstig, wenn die Umwälzpumpe einen Elektromotor umfaßt, mit einem Stator und einem Rotor (Läufer), zwischen welchen ein sphärischer Luftspalt gebildet ist. Eine Kreiselpumpe mit einem solchen Elektromotor ist in der DE 35 38 504 C2 offenbart, auf die hiermit ausdrücklich Bezug genommen wird.

Weiterhin ist es günstig, wenn die Umwälzpumpe mindestens im Bereich zwischen einem Einströmbereich und einem Ausströmbereich koaxial durchströmt ist, um so eine optimale Verteilung der Kühl- bzw. Heizflüssigkeit an dem thermischen Kontaktelement zu erhalten.

Um die Abmessungen der erfindungsgemäßen Vorrichtung zu minimieren, ist vorteilhafterweise eine Zuführungsleitung für flüssiges Medium quer zu einer Drehachse eines Rotors der Umwälzpumpe an ein Gehäuse der Umwälzpumpe gekoppelt und/oder eine Abführungsleitung für flüssiges Medium quer zu einer Drehachse eines Rotors der Umwälzpumpe an ein Gehäuse der Umwälzpumpe gekoppelt. Insbesondere ist dabei die Zuführungsleitung bzw. Abführungsleitung senkrecht bezüglich der Drehachse an das Gehäuse gekoppelt. Dadurch läßt sich flüssiges Medium seitlich zuführen bzw. abführen, so daß die Gesamthöhe der Vorrichtung nicht erhöht wird.

Sind eine Abführungsleitung für flüssiges Medium von der Umwälzpumpe und eine Zuführungsleitung für flüssiges Medium zu der Umwälzpumpe an der gleichen Seite eines Gehäuses der Umwälzpumpe gekoppelt, dann lassen sich auch die seitlichen Abmessungen der Vorrichtung und insbesondere der Platzbedarf für die Ausbildung eines Kreislaufs für das flüssige Medium minimieren.

Vorteilhafterweise ist das thermische Kontaktelement an der Druckseite der Umwälzpumpe angeordnet (und nicht an der Saugseite), um so eine optimale Strömungsführung zu erhalten und insbesondere das thermische Kontaktelement mit einer Strömung mit hohem Turbulenzgrad beaufschlagen zu können, um so wiederum eine optimale Wärmeankopplung zu erreichen.

Um die thermische Kontaktfläche der Flüssigkeit in dem thermischen Kontaktelement zu erhöhen, kann es vorgesehen sein, daß das thermische Kontaktelement auf seiner Innenseite eine Verrippung aufweist. Es kann sich dabei beispielsweise um kreisförmige oder spiralförmige Wände handeln.

Bei einer Variante einer Ausführungsform ist die Verrippung so ausgebildet, daß sie turbulenzfördernd ist, um so die thermische Ankopplung weiter zu verbessern.

Bei einer Variante einer Ausführungsform ist es vorgesehen, daß in einem Luftspalt zwischen einem Stator und einem Rotor am Rotor Schaufeln angeordnet sind, um in der Flüssigkeit insbesondere zusätzlich einen Drall zu erzeugen. Die Schaufeln sind dabei so angeordnet, daß die sphärische Geometrie im wesentlichen beibehalten bleibt.

Es kann vorgesehen sein, daß ein Drallraum der Umwälzpumpe ein variables Volumen aufweist und insbesondere ein Begrenzungselement des Drallraums relativ zu dem restlichen Gehäuse beweglich ist. Dadurch ist ein Ausdehnungsvolumen für die Flüssigkeit bereitstellbar, ohne daß separate Ausdehnungseinrichtungen vorgesehen werden müssen. (Die Flüssigkeit dehnt sich bei Erwärmung aus.) Weiterhin läßt sich so ein Vordruck ausüben, um insbesondere das Eindringen von Luft in das System zu verhindern.

Insbesondere ist es vorgesehen, daß die Umwälzpumpe ein Gehäuseteil aufweist, welches derart flexibel ausgebildet ist und/oder beweglich ist und dabei insbesondere beweglich am Gehäuse angeordnet ist, daß ein Vordruck auf das System ausübbar ist. Dadurch läßt sich das Eindringen von Luft in das System verhindern. Beispielsweise kann es sich bei dem Gehäuseteil um eine flexible Platte handeln, um eine flexible Membran oder einen Faltenbalg.

Insbesondere ist es vorgesehen, daß ein Vordruck auf das System mittels einer Fixierungsvorrichtung für die Umwälzpumpe an dem Gegenstand ausübbar ist. Über eine solche Fixierungsvorrichtung läßt sich die Umwälzpumpe mit dem Kontaktelement an bzw. bezüglich des zu kühlenden bzw. zu erhitzenden Gegenstands fixieren. Dies kann dadurch erfolgen, daß eine entsprechende Haltekraft ausgeübt wird. Diese Haltekraft läßt sich eben dazu nutzen, den Vordruck auszuüben, wobei die Kraft direkt auf das flexible und/oder bewegliche Gehäuseteil wirken kann oder diese Kraft über die Haltekraft vermittelt wird.

Insbesondere ist es vorgesehen, daß die Umwälzpumpe mittels einer oder mehreren Klammern bezüglich des Gegenstands gehalten ist. Dadurch läßt sich eine einfache Fixierung der Umwälzpumpe und damit der Vorrichtung zur lokalen Kühlung oder Erwärmung bezüglich des Gegenstands erreichen.

Die nachfolgende Beschreibung bevorzugter Ausführungsformen dient im Zusammenhang mit der Zeichnung der näheren Erläuterung der Erfindung.
Es zeigen:
- Figur 1: eine seitliche (Teil-) Schnittansicht eines Ausführungsbeispiels einer erfindungsgemäßen Vorrichtung zur lokalen Kühlung oder Erwärmung eines Gegenstandes;
- Figur 2: eine Draufsicht in der Richtung A auf die Vorrichtung gemäß Figur 1;
- Figur 3: eine schematische Darstellung eines Ausführungsbeispiels eines thermischen Kontaktelements;
- Figur 4: ein weiteres Ausführungsbeispiel eines thermischen Kontaktelements;
- Figur 5: ein weiteres Ausführungsbeispiel eines thermischen Kontaktelements;
- Figur 6: eine schematische Ansicht einer Fixierungsvorrichtung zur Fixierung einer Umwälzpumpe an dem Gegenstand, und
- Figur 7: eine Variante des Ausführungsbeispiels gemäß Figur 5.

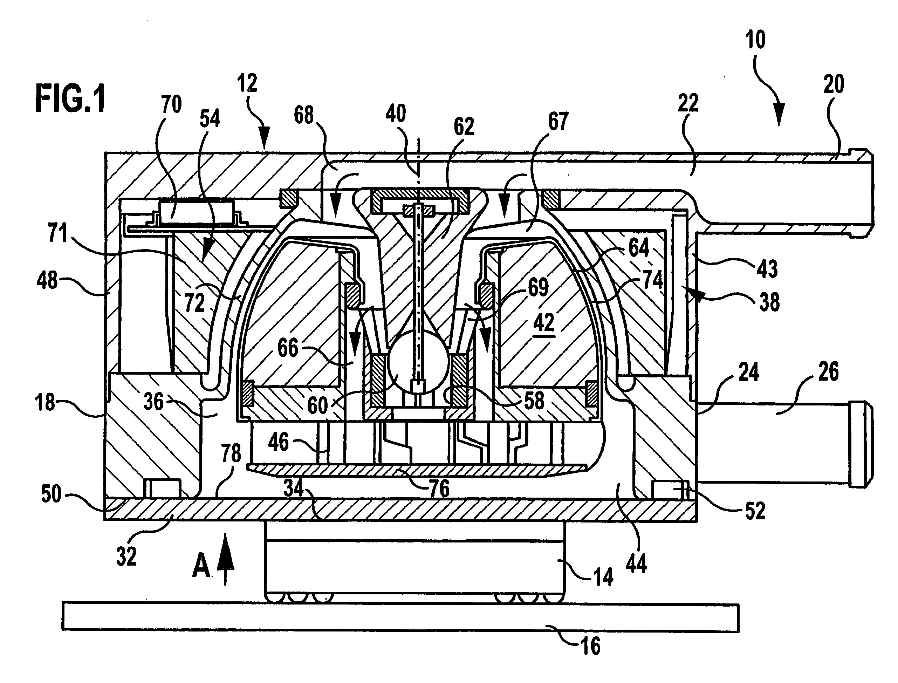

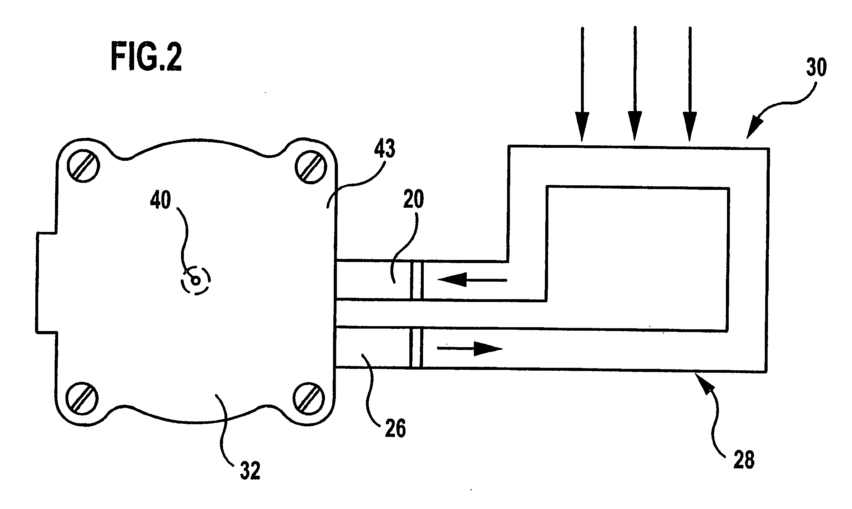

Ein Ausführungsbeispiel einer erfindungsgemäßen Vorrichtung zur lokalen Kühlung oder Erwärmung eines Gegenstandes, welche in Figur 1 als Ganzes mit 10 bezeichnet ist, umfaßt eine Umwälzpumpe 12, mittels welcher eine Flüssigkeit wie Wasser als Wärmeübertragungsmedium in einem Kreislauf (Figur 2) führbar ist. Das Wärmeübertragungsmedium kann als Kühlmedium dienen, um einen Gegenstand 14 wie beispielsweise ein elektronisches Bauteil wie einen Prozessor, welcher auf einer Platine 16 sitzt, zu kühlen. Das Wärmeübertragungsmedium kann aber auch als Heizflüssigkeit dienen, um einen Gegenstand zu heizen.

Die Umwälzpumpe 12 umfaßt ein Gehäuse 18. In dieses Gehäuse 18 mündet eine Zuführungsleitung 20 für die Flüssigkeit mit einer Mündungsöffnung 22 in eine Saugseite der Umwälzpumpe 12. Von dem Gehäuse 18 ist über eine Öffnung 24 eine Abführungsleitung 26 von einer Druckseite der Umwälzpumpe 12 weggeführt.

Das Gehäuse 18 ist beispielsweise über Anpreßklammern an den Gegenstand 14 gedrückt.

Bei der Verwendung als Kühlvorrichtung wird über die Zuführungsleitung 20 Kühlflüssigkeit wie Wasser zugeführt und über die Abführungsleitung 26 wird erwärmte Kühlflüssigkeit abgeführt, die über die Kühlung des Gegenstandes 14 sich erwärmt hat.

Bei dem Einsatz als Heizvorrichtung wird über die Zuführungsleitung 20 Heizflüssigkeit zugeführt, die dann den Gegenstand 14 heizt und sich dabei abkühlt. Die abgekühlte Heizflüssigkeit wird über die Abführungsleitung 26 abgeführt.

Die Abführungsleitung 26 und die Zuführungsleitung 20 sind außerhalb des Gehäuses 18 der Umwälzpumpe 12 miteinander verbunden, um einen Kreislauf 28 für die Flüssigkeit zu bilden. Dieser Kreislauf 28 weist dabei eine außerhalb des Gehäuses 18 angeordnete Kühlstrecke oder Heizstrecke 30 auf, an der sich erwärmte Kühlflüssigkeit abkühlen läßt, beispielsweise über Luftkühlung, oder abgekühltes Heizmedium aufheizen läßt. Die Kühlstrecke oder Heizstrecke 30 weist dazu eine entsprechende Oberfläche auf, um eine effektive Kühlung bzw. Heizung zu ermöglichen.

Der thermische Kontakt zwischen der Flüssigkeit und dem Gegenstand 14 wird durch ein thermisches Kontaktelement 32 vermittelt, welches in die Umwälzpumpe 12 integriert ist. Vorzugsweise bildet das thermische Kontaktelement 32 einen Gehäusedeckel für das Gehäuse 18 aus und ist beispielsweise plattenförmig und aus einem metallischen Material hergestellt.

Das thermische Kontaktelement 32 berührt, um den thermischen Kontakt herzustellen, den Gegenstand 14 in einem möglichst großen Oberflächenbereich. Vorzugsweise ist die dem Gegenstand 14 zugewandte Fläche des thermischen Kontaktelements 32 mindestens so groß wie eine Kontaktoberfläche des Gegenstands 14.

In dem Gehäuse 18 der Umwälzpumpe 12 ist ein Innenraum 36 gebildet, in dem ein als Ganzes mit 38 bezeichneter Elektromotor aufgenommen ist. Dieser umfaßt einen um eine Drehachse 40 rotierbaren Rotor 42.

Die Mündungsöffnung 22 für die Zuführungsleitung 20 und die Zuführungsleitung 20 zumindest im Bereich der Mündungsöffnung sowie die Öffnung 24 und die Abführungsleitung 26 zumindest im Bereich dieser Öffnung 24 sind dabei quer und insbesondere senkrecht zu der Drehachse 40 orientiert, um so die Höhe der Umwälzpumpe 12 und damit der Vorrichtung 10 in Richtung der Drehachse 40 gering halten zu können.

Vorzugsweise sind dabei die Mündungsöffnung 22 und die Mündungsöffnung 24 an einer gleichen (Quer-) Seite 43 des Gehäuses 18 der Umwälzpumpe 12 angeordnet.

In dem Innenraum 36 des Gehäuses 18 ist ein Drallraum 44 gebildet, in dem über die Zuführungsleitung 20 zugeführte Flüssigkeit über ein Schaufelrad 46, welches drehfest mit dem Rotor 42 verbunden ist, ein Drall erzeugt wird und Flüssigkeit mit Drall strömt. Es erfolgt in einem Spiralgehäuse der Umwälzpumpe 12 eine Druckumsetzung, um so die Flüssigkeit durch den Kreislauf 28 zu pumpen. Die Flüssigkeit wird auch an dem thermischen Kontaktelement 32 zur Wärmeübertragung vorbeigeführt.

Der Drallraum 44 ist in dem Innenraum 36 zwischen Wänden 48 gebildet, wobei an diesen Wänden wiederum dem Gegenstand 14 zugewandt das thermische Kontaktelement 32 sitzt. Zwischen Stirnflächen 50 dieser Wände 48 und dem thermischen Kontaktelement 32 ist eine oder sind mehrere Fluiddichtungen 52 beispielsweise in der Form von O-Ringen angeordnet.

Der Elektromotor 38 der Umwälzpumpe 12 kann beispielsweise als Zylindermotor, als Scheibenmotor oder als Außenläufermotor ausgebildet sein oder die Umwälzpumpe kann über eine permanentmagnetische Kupplung angetrieben sein.

Bei dem in Figur 1 gezeigten Ausführungsbeispiel ist die Umwälzpumpe 12 als Kreiselpumpe mit einem entsprechenden Elektromotor 38 ausgebildet, welcher einen drehfest mit dem Gehäuse 18 verbundenen Stator 54 und einen drehbar gelagerten Rotor (Läufer) 42 umfassen.

Der Rotor 42 ist dabei über eine Lagerpfanne 58 an einem konvexen Gleitpartner 60 gelagert.

Der konvexe Gleitpartner 60, welcher insbesondere als Kugel ausgebildet ist, sitzt an einer Lagersäule 62, welche sich in Richtung der Drehachse 40 erstreckt und insbesondere konzentrisch zu dieser ausgebildet ist.

Die Lagerpfanne 58 ist drehfest mit dem Schaufelrad 46 verbunden.

Durch die Lagerpfanne 58 an dem Gleitpartner 60 ist ein sphärisches Lager gebildet. Dadurch sind die Abmessungen der Umwälzpumpe 12 für die Lagerung des Rotors 42 in Richtung der Drehachse 40 minimierbar.

Der Rotor 42 des Elektromotors 38 weist eine den Wänden 48 des Gehäuses 18 zugewandte sphärische Kontur auf, das heißt eine einem Teilbereich einer Kugeloberfläche entsprechende Kontur auf. Eine Hülle 64, welche beispielsweise aus Edelstahl gefertigt ist, umgibt dabei den Rotor 42. Der Rotor 42 bildet mit dem Schaufelrad 46 eine Einheit.

Um die Lagersäule 62 ist an dem Rotor 42 ein Durchströmungsraum 66 gebildet, welcher insbesondere konzentrisch zu der Drehachse 40 angeordnet ist und beispielsweise im Querschnitt näherungsweise ringförmig (mit im Ringraum angeordneten Rippen) ist. Dieser Durchströmungsbereich 66 verbindet einen Einströmbereich 68 der Umwälzpumpe 12, welche wiederum mit der Zuführungsleitung 20 verbunden ist, mit dem Drallraum 44. Das Schaufelrad 46 ist in dem Drallraum 44 angeordnet, so daß hier die Druckseite der Umwälzpumpe 12 gebildet ist, während der Einströmbereich 68 die Saugseite darstellt. Über den Durchströmungsraum 66 wird dann Flüssigkeit durch die Umwälzpumpe 12 durchgeführt, durch das Schaufelrad 46 wird der durchgeführten Flüssigkeit ein Drall erteilt; es wird dann der erforderliche Druck zum Durchpumpen der Flüssigkeit durch den Kreislauf 28 erzeugt.

Über radiale Rippen 67 ist die Lagersäule 62 an dem Gehäuse 18 gehalten, wobei eine Vorbeiströmbarkeit der Flüssigkeit gewährleistet ist. Über radiale Rippen 69 ist die Lagerpfanne 58 drehfest an dem Rotor 42 gehalten, wobei zur Bildung des Durchströmungsraums 66 wiederum eine Vorbeiströmbarkeit gewährleistet ist.

In dem Gehäuse 18 sitzt bei einer Variante einer Ausführungsform eine Platine 70.

Der Stator 54 ist mittels Spulenwicklungen (in der Zeichnung nicht gezeigt) und Rückschlußelementen 71 gebildet.

Zwischen dem Rotor 42 und dem Stator 54 ist eine sphärische Wand 72 angeordnet, die beispielsweise aus einem Kunststoffmaterial hergestellt ist. Zwischen dem Rotor 42 und dem sphärischen Stator 54 ist ein Luftspalt 74 gebildet, welcher sphärisch ist, das heißt zu der Wand 72 durch einen Teil einer Kugeloberfläche begrenzt ist und zu dem Rotor 42 hin ebenfalls durch den Teil einer Kugeloberfläche begrenzt ist, wobei die beiden Kugeloberflächen nahezu konzentrisch zueinander liegen. Die Kugelzentren liegen dabei auf der Drehachse 40 im Zentrum des Gleitpartners 60, über den wiederum mittels der Lagerpfanne 58 der Rotor 42 drehbar in dem Gehäuse 18 der Umwälzpumpe 12 gelagert ist. Nur bezüglich der Richtung längs der Drehachse 40 dürfen die Kugeloberflächen leicht unkonzentrisch liegen.

Das Schaufelrad 46 sitzt in dem Drallraum 44 dem thermischen Kontaktelement 32 zugewandt. Es kann vorgesehen sein, daß das Schaufelrad 46 dem thermischen Kontaktelement 32 zugewandt mit einer Deckplatte 76 versehen ist.

Die erfindungsgemäße Vorrichtung 10 zur Kühlung oder Heizung des Gegenstandes 14 funktioniert wie folgt:

Das Gehäuse 18 der Umwälzpumpe 12 wird so bezüglich des Gegenstandes 14 positioniert, daß das thermische Kontaktelement 32 an der Kontaktoberfläche 34 des Gegenstandes 14 sitzt.

Beispielsweise ist der Gegenstand 14 ein Mikroprozessor, der über Wasser gekühlt werden soll.

Durch die Umwälzpumpe 12 wird dann Kühlwasser in dem Kreislauf 14 an einer Innenseite 78 des thermischen Kontaktelements 32, welche der Kontaktoberfläche 34 des Gegenstandes 14 abgewandt ist, vorbeigeführt.

Es kann dabei vorgesehen sein, daß diese Innenseite eine Verrippung zur Flächenerhöhung aufweist, welche insbesondere mit einer turbulenzfördernden Struktur versehen ist. Beispielsweise ragen kreisförmig oder spiralförmig ausgebildete Wände in Richtung des Schaufelrades 46. Dadurch läßt sich die Strömung und insbesondere die Vorbeiströmung des Kühlwassers an dem thermischen Kontaktelement 32 verbessern und der Wärmekontakt verbessern, so daß optimal Wärme abführbar ist und damit der Gegenstand 14 optimal kühlbar ist.

Über die Zuführungsleitung 20 wird kühles Kühlwasser in den Einströmbereich 68 geführt. Dieses durchströmt dann den Durchströmungsraum 66 koaxial zur Drehachse 40. Durch das Schaufelrad 46 wird diesem Kühlwasser ein Drall erteilt; es erfolgt dann in dem Spiralgehäuse eine Druckumsetzung, um das Kühlwasser durch den Kreislauf 28 zu pumpen.

An dem Schaufelrad 46 strömt dabei das Kühlwasser bezogen auf die Drehachse 40 spiralig nach außen und an der Innenseite 78 des thermischen Kontaktelements 32 vorbei. Dadurch kann Wärme von dem thermischen Kontaktelement 32 und damit wiederum von dem Gegenstand 14 durch das Kühlwasser abgeführt werden, das entsprechend diese Wärme aufgenommen hat.

Die Kühlstrecke 30 weist beispielsweise eine 3-fach bis 30-fach größere Wärmeübergangsfläche auf als es der Fläche der Innenseite 78 des thermischen Kontaktelements 32 entspricht, über welche Wärme an das Kühlwasser abgebbar ist.

Es kann vorgesehen sein, daß alternativ oder zusätzlich zum Schaufelrad 46 in dem Luftspalt 74 an dem Rotor 42 Schaufeln angeordnet sind, wobei die Kugelsymmetrie der Anordnung im wesentlichen beibehalten ist.

Erfindungsgemäß ist eine Kreiselpumpe als Umwälzpumpe 12 vorgesehen mit einer sphärischen Lagerung des Rotors 42. Durch diese sphärische Lagerung über die Lagerpfanne 58 und den Gleitpartner 60 ergibt sich eine hohe Spielfreiheit und damit eine hohe Lebensdauer der Umwälzpumpe 12 bei gleichzeitig geringer Geräuschbildung während des Betriebs.

Weiterhin lassen sich geringe Bauhöhen in Richtung der Drehachse 14 realisieren, so daß sich eine kompakte Vorrichtung beispielsweise zur Kühlung eines Mikroprozessors 14 realisieren läßt. Durch die Integration des thermischen Kontaktelements 32 in die Umwälzpumpe 12 und insbesondere durch die Ausbildung als Gehäusedeckel läßt sich ein einfacher und platzsparender Aufbau der Vorrichtung 10 realisieren. Insbesondere ist kein externes thermisches Kontaktelement notwendig. Die hohen Strömungsgeschwindigkeiten innerhalb des Gehäuses 18 der Umwälzpumpe 12 lassen sich direkt dazu nutzen, um Wärme von dem Gegenstand 14 abzuführen. Das Schaufelrad 46 ist dabei direkt dem thermischen Kontaktelement 32 und damit dem Gegenstand 14 zugewandt.

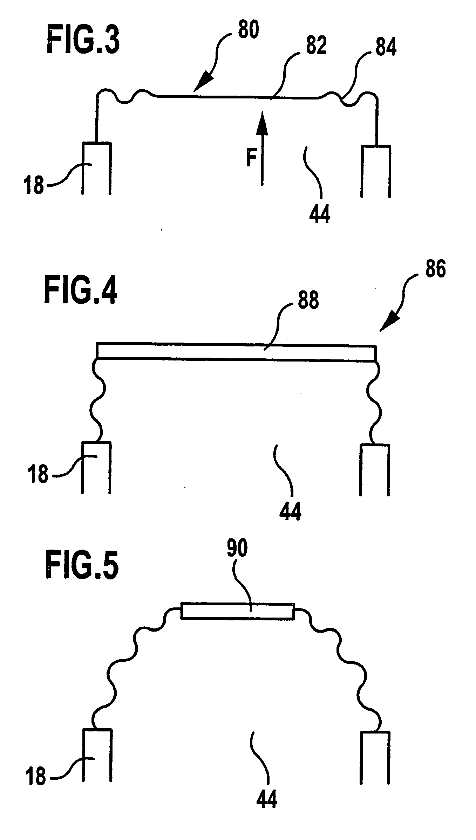

Das thermische Kontaktelement ist dabei elastisch ausgebildet. Bei einem Ausführungsbeispiel, welches in Figur 3 gezeigt ist, ist eine flexible Platte 80 als thermisches Kontaktelement 32 vorgesehen, welche eine genügende Eigensteifigkeit aufweist. Insbesondere umfaßt die flexible Platte 80 einen thermischen Kontaktbereich 82 und einen Flexibilitätsbereich 84, um so einen optimalen Kontakt zwischen der Platte 80 und dem Gegenstand 14 zu bewirken.

Durch die Flexibilität des thermischen Kontaktelements 80 ist dabei das Volumen des Drallraums 44 variabel ausgestaltet. Dadurch kann eine Ausdehnung der Flüssigkeit ohne Belastung des Gehäuses 18 aufgefangen werden. Außerdem läßt sich so ein Vordruck auf das System ausüben.

Es kann auch vorgesehen sein, daß das thermische Kontaktelement eine Membran umfaßt, die sich an den Gegenstand 14 anlegt bzw. eine flexible Membran umfaßt.

Bei einem in Figur 4 gezeigten Ausführungsbeispiel umfaßt das thermische Kontaktelement einen Faltenbalg 86 mit einer Kontaktplatte 88 zum Anlegen an den Gegenstand 14. Über die Ausbildung als Faltenbalg 86 ist dabei die Kontaktplatte 88 relativ zudem Schaufelrad 46 verschieblich, wobei dadurch wiederum das Volumen des Drallraums 44 variabel ist.

Es kann auch vorgesehen sein, daß ein thermisches Kontaktelement 90, wie in Figur 5 gezeigt, in einer konischen Anordnung vorliegt, wobei es sich um eine starre Anordnung oder um eine flexible Anordnung handeln kann.

Die erfindungsgemäße Vorrichtung 10 läßt sich auch zur lokalen Heizung des Gegenstandes 14 über das thermische Kontaktelement 32 und die Kontaktoberfläche 34 des Gegenstandes 14 nutzen, wenn entsprechend insbesondere Heizwasser als Heizflüssigkeit an der Innenseite 78 des thermischen Kontaktelements 32 vorbeigeführt wird.

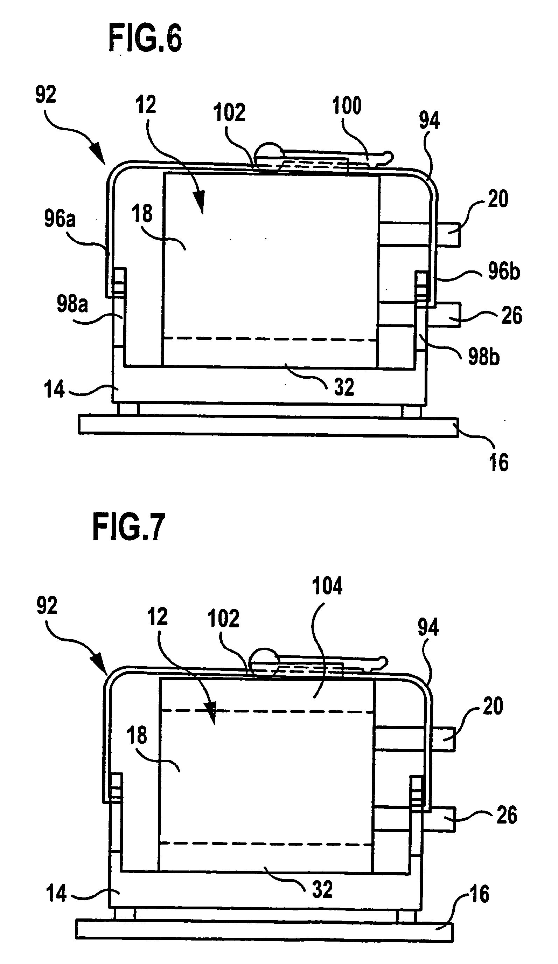

Die Umwälzpumpe 12 ist, wie in Figur 6 und Figur 7 gezeigt, mittels einer Fixierungsvorrichtung 92 an dem Gegenstand 14, der zu kühlen oder zu erwärmen ist, fixiert. Beispielsweise umfaßt die Fixierungsvorrichtung 92 eine oder mehrere Halteklammern 94. Bei mehreren Halteklammern 94 sind diese beabstandet angeordnet.

Eine Halteklammer 94 ist bügelförmig ausgebildet und an einer dem thermischen Kontaktelement 32 abgewandten Seite des Gehäuses 18 anlegbar. Über Enden 96a, 96b ist eine Halteklammer 94 an dem Gegenstand 14 fixiert, der dazu entsprechende Halteaufnahmen 98a, 98b aufweist. Diese Halteaufnahmen können aber auch an der Platine 16 oder an einer Basis angeordnet sein, welche die Platine 16 aufnimmt.

Die Halteklammer 94 ist als Spannbügel ausgebildet mit einem Spannhebel 100. Ist dieser Spannhebel 100 geöffnet, dann läßt sich die Umwälzpumpe 12 auf den Gegenstand 14 aufsetzen bzw. die Umwälzpumpe 12 läßt sich in den Zwischenraum zwischen der Halteklammer 94 und dem Gegenstand 14 schieben. Wird dann der Spannhebel umgelegt, wobei in Figur 6 die umgelegte Stellung gezeigt ist, dann wird über einen Bügelbereich 102 eine Kraft in Richtung des Gegenstands 14 ausgeübt, wodurch wiederum das Gehäuse 18 der Umwälzpumpe 12 an den Gegenstand 14 gedrückt wird und damit die Umwälzpumpe 12 mit dem Kontaktelement 32 an dem Gegenstand 14 fixiert ist bzw. bezüglich dieses Gegenstands 14 fixiert ist.

Mit solchen Halteklammern 94 läßt sich eine schnelle Fixierung der Umwälzpumpe 12 an dem Gegenstand 14 erreichen bzw. die Umwälzpumpe 12 läßt sich schnell austauschen.

Damit das thermische Kontaktelement 32 als flexibles Kontaktelement bzw. bezüglich dem Gehäuse 18 beweglichen Kontaktelement ausgebildet ist, läßt sich über die Fixierungsvorrichtung 92 und die Halteklammern 94 ein Vordruck auf das System ausüben, um das Eindringen von Luft zu verhindern. In diesem Fall bildet das thermische Kontaktelement ein Gehäuseteil aus, das flexibel ist oder beweglich an dem Gehäuse 18 gelagert ist, und mit dessen Hilfe sich ein Vordruck auf das System ausüben läßt.

Bei dem in Figur 6 gezeigten Ausführungsbeispiel wird der Vordruck über die Halteklammern 94 indirekt über Andrücken des Gehäuses 18 der Umwälzpumpe 12 an den Gegenstand 14 ausgeübt, weil das thermische Kontaktelement flexibel und/oder beweglich ausgestaltet ist.

## Patentansprüche

1. Vorrichtung zur lokalen Kühlung oder Erwärmung eines Gegenstandes (14) mittels einer Flüssigkeit, umfassend eine Umwälzpumpe (12) für die Flüssigkeit, wobei ein thermisches Kontaktelement (32; 80; 86; 90) für die thermische Kontaktierung des Gegenstandes (14) in die Umwälzpumpe (12) integriert ist und Flüssigkeit an dem thermischen Kontaktelement (32; 80; 86; 90) vorbeigeführt wird,
**dadurch gekennzeichnet , daß** das thermische Kontaktelement (32; 80; 86; 90) Teil eines Gehäuses (18) der Umwälzpumpe (12) ist und daß das thermische Kontaktelement (80; 86; 90) flexibel ausgebildet ist und/oder beweglich an dem Gehäuse (18) der Umwälzpumpe (12) gelagert ist.

2. Vorrichtung nach Anspruch 1, **dadurch gekennzeichnet, daß** das thermische Kontaktelement (32) einen Gehäusedeckel der Umwälzpumpe (12) bildet.

3. Vorrichtung nach einem der vorangehenden Ansprüche, **dadurch gekennzeichnet, daß** das thermische Kontaktelement (32; 80; 86; 90) einen Drallraum (44) der Umwälzpumpe (12) begrenzt.

4. Vorrichtung nach Anspruch 3, **dadurch gekennzeichnet, daß** in dem Drallraum (44) ein Schaufelrad (46) rotierbar ist.

5. Vorrichtung nach Anspruch 4, **dadurch gekennzeichnet, daß** die Umwälzpumpe (12) eine Deckplatte für das Schaufelrad (46) aufweist.

6. Vorrichtung nach Anspruch 4 oder 5, **dadurch gekennzeichnet, daß** eine Durchsatzströmung, welche mittels des Schaufelrads (46) erzeugt ist, an dem thermischen Kontaktelement (32; 80; 86; 90) vorbeigeführt ist.

7. Vorrichtung nach einem der Ansprüche 4 bis 6, **dadurch gekennzeichnet, daß** das Schaufelrad (46) dem thermischen Kontaktelement (32; 80; 86; 90) zugewandt angeordnet ist.

8. Vorrichtung nach einem der vorangehenden Ansprüche, **dadurch gekennzeichnet, daß** das thermische Kontaktelement (32) aus einem metallischen Material hergestellt ist.

9. Vorrichtung nach einem der vorangehenden Ansprüche, **dadurch gekennzeichnet, daß** das thermische Kontaktelement (32) als Platte ausgebildet ist.

10. Vorrichtung nach einem der vorangehenden Ansprüche, **dadurch gekennzeichnet, daß** die Umwälzpumpe (12) als Kreiselpumpe ausgebildet ist.

11. Vorrichtung nach Anspruch 10, **dadurch gekennzeichnet, daß** ein sphärisches Lager (58, 60) für einen Rotor (42) der Umwälzpumpe (12) vorgesehen ist.

12. Vorrichtung nach Anspruch 10 oder 11, **dadurch gekennzeichnet, daß** die Umwälzpumpe (12) einen Elektromotor (38) umfaßt mit einem Stator (54) und einem Rotor (42), zwischen welchen ein sphärischer Luftspalt (74) gebildet ist.

13. Vorrichtung nach einem der Ansprüche 10 bis 11, **dadurch gekennzeichnet, daß** die Umwälzpumpe (12) koaxial durchströmt ist.

14. Vorrichtung nach einem der vorangehenden Ansprüche, **dadurch gekennzeichnet, daß** eine Zuführungsleitung (20) für flüssiges Medium quer zu einer Drehachse (40) eines Rotors (42) der Umwälzpumpe (12) an ein Gehäuse (18) der Umwälzpumpe (12) gekoppelt ist.

15. Vorrichtung nach einem der vorangehenden Ansprüche, **dadurch gekennzeichnet, daß** eine Abführungsleitung (26) für flüssiges Medium quer zu einer Drehachse (40) eines Rotors (42) der Umwälzpumpe (12) an ein Gehäuse (18) der Umwälzpumpe (12) gekoppelt ist.

16. Vorrichtung nach einem der vorangehenden Ansprüche, **dadurch gekennzeichnet, daß** eine Abführungsleitung (26) für flüssiges Medium von der Umwälzpumpe (12) und eine Zuführungsleitung (20) für flüssiges Medium zu der Umwälzpumpe (12) an der gleichen Seite (43) eines Gehäuses (18) der Umwälzpumpe (12) angekoppelt sind.

17. Vorrichtung nach einem der vorangehenden Ansprüche, **dadurch gekennzeichnet, daß** das thermische Kontaktelement (32; 80; 86; 90) an der Druckseite der Umwälzpumpe (12) angeordnet ist.

18. Vorrichtung nach einem der vorangehenden Ansprüche, **dadurch gekennzeichnet, daß** das thermische Kontaktelement (32; 80; 86; 90) auf seiner Innenseite (78) eine Verrippung aufweist.

19. Vorrichtung nach Anspruch 18, **dadurch gekennzeichnet, daß** die Verrippung so ausgebildet ist, daß sie turbulenzfördernd ist.

20. Vorrichtung nach einem der vorangehenden Ansprüche, **dadurch gekennzeichnet, daß** in einem Luftspalt (74) zwischen einem Stator (54) und einem Rotor (42) am Rotor (42) Schaufeln angeordnet sind.

21. Vorrichtung nach einem der vorangehenden Ansprüche, **dadurch gekennzeichnet, daß** ein Drallraum (44) der Umwälzpumpe (12) ein variables Volumen aufweist.

22. Vorrichtung nach einem der vorangehenden Ansprüche, **dadurch gekennzeichnet, daß** das thermische Kontaktelement derart flexibel ausgebildet und/oder beweglich ist, daß ein Vordruck auf das System ausübbar ist.

23. Vorrichtung nach einem der vorangehenden Ansprüche, **dadurch gekennzeichnet, daß** das thermische Kontaktelement derart flexibel ausgebildet und/oder beweglich ist, daß ein Ausdehnungsvolumen für die Flüssigkeit bereitstellbar ist.

24. Vorrichtung nach Anspruch 22 oder 23, **dadurch gekennzeichnet, daß** ein Vordruck auf das System mittels einer Fixierungsvorrichtung (92) für die Umwälzpumpe (12) an dem Gegenstand (14) ausübbar ist.

25. Vorrichtung nach einem der vorangehenden Ansprüche, **dadurch gekennzeichnet, daß** die Umwälzpumpe (12) mittels einer oder mehrerer Halteklammern (94) bezüglich des Gegenstands (14) gehalten ist.

## Claims

1. Device for the local cooling or heating of an object (14) by means of a liquid, comprising a circulation pump (12) for the liquid, wherein a thermal contact element (32; 80; 86; 90) for making thermal contact with the object (14) is integrated in said circulation pump (12) and liquid is guided past the thermal contact element (32; 80; 86; 90), **characterized in that** the thermal contact element (32; 80; 86; 90) is part of a housing (18) of the circulation pump (12) and **in that** the thermal contact element (80; 86; 90) is of flexible configuration and/or mounted for movement on the housing (18) of the circulation pump (12).

2. Device in accordance with claim 1, **characterized in that** the thermal contact element (32) forms a housing cover of the circulation pump (12).

3. Device in accordance with any one of the preceding claims, **characterized in that** the thermal contact element (32; 80; 86; 90) defines a boundary of a swirl chamber (44) of the circulation pump (12).

4. Device in accordance with claim 3, **characterized in that** an impeller (46) is rotatably arranged in the swirl chamber (44).

5. Device in accordance with claim 4, **characterized in that** the circulation pump (12) has a cover plate for the impeller (46).

6. Device in accordance with claim 4 or 5, **characterized in that** a throughflow which is generated by means of the impeller (46) is guided past the thermal contact element (32; 80; 86; 90).

7. Device in accordance with any one of claims 4 to 6, **characterized in that** the impeller (46) is arranged facing the thermal contact element (32; 80; 86; 90).

8. Device in accordance with any one of the preceding claims, **characterized in that** the thermal contact element (32) is made from a metallic material.

9. Device in accordance with any one of the preceding claims, **characterized in that** the thermal contact element (32) is configured as a plate.

10. Device in accordance with any one of the preceding claims, **characterized in that** the circulation pump (12) is configured as a centrifugal pump.

11. Device in accordance with claim 10, **characterized in that** a spherical bearing (58, 60) is provided for a rotor (42) of the circulation pump (12).

12. Device in accordance with claim 10 or 11, **characterized in that** the circulation pump (12) comprises an electric motor (38) having a stator (54) and a rotor (42), between which a spherical air gap (74) is formed.

13. Device in accordance with any one of claims 10 to 11, **characterized in that** there is coaxial flow through the circulation pump (12).

14. Device in accordance with any one of the preceding claims, **characterized in that** a feed conduit (20) for liquid medium is connected to a housing (18) of the circulation pump (12) transversely with respect to a rotation axis (40) of a rotor (42) of the circulation pump (12).

15. Device in accordance with any one of the preceding claims, **characterized in that** a discharge conduit (26) for liquid medium is connected to a housing (18) of the circulation pump (12) transversely with respect to a rotation axis (40) of a rotor (42) of the circulation pump (12).

16. Device in accordance with any one of the preceding claims, **characterized in that** a discharge conduit (26) for discharging liquid medium from the circulation pump (12) and a feed conduit (20) for feeding liquid medium to the circulation pump (12) are connected to the same side (43) of a housing (18) of the circulation pump (12).

17. Device in accordance with any one of the preceding claims, **characterized in that** the thermal contact element (32; 80; 86; 90) is arranged on the pressure side of the circulation pump (12).

18. Device in accordance with any one of the preceding claims, **characterized in that** the thermal contact element (32; 80; 86; 90) has fins on its inner side (78).

19. Device in accordance with claim 18, **characterized in that** the fins are configured in such a way as to promote turbulence.

20. Device in accordance with any one of the preceding claims, **characterized in that** in an air gap (74) between a stator (54) and a rotor (42) blades are arranged on the rotor (42).

21. Device in accordance with any one of the preceding claims, **characterized in that** a swirl chamber (44) of the circulation pump (12) has a variable volume.

22. Device in accordance with any one of the preceding claims, **characterized in that** the thermal contact element is of flexible configuration and/or movable in such a manner that a pressure bias can be exerted on the system.

23. Device in accordance with any one of the preceding claims, **characterized in that** the thermal contact element is of flexible configuration and/or movable in such a manner that it is possible to provide an expansion volume for the liquid.

24. Device in accordance with claim 22 or 23, **characterized in that** a pressure bias is exertable on the system by means of a fixing device (92) for fixing the circulation pump (12) to the object (14).

25. Device in accordance with any one of the preceding claims, **characterized in that** the circulation pump (12) is held with respect to the object (14) by means of one or more holding clips (94).

## Revendications

1. Dispositif pour le refroidissement ou le réchauffement localisé d'un objet (14) au moyen d'un liquide, comprenant une pompe de recirculation (12) pour le liquide, dans lequel un élément de contact thermique (32 ; 80 ; 86 ; 90) pour la mise en contact thermique de l'objet (14) est intégré dans la pompe de recirculation (12), et le liquide est amené à passer le long de l'élément de contact thermique (32 ; 80 ; 86 ; 90),
**caractérisé en ce que** l'élément de contact thermique (32 ; 80 ; 86 ; 90) fait partie d'un boîtier (18) de la pompe de recirculation (12), et **en ce que** l'élément de contact thermique (80 ; 86 ; 90) est réalisé flexible et/ou est monté de façon mobile sur le boîtier (18) de la pompe de recirculation (12)

2. Dispositif selon la revendication 1, **caractérisé en ce que** l'élément de contact thermique (32) forme un couvercle du boîtier de la pompe de recirculation (12).

3. Dispositif selon l'une des revendications précédentes, **caractérisé en ce que** l'élément de contact thermique (32 ; 80 ; 86 ; 90) délimite une chambre de tourbillonnements (44) de la pompe de recirculation (12).

4. Dispositif selon la revendication 3, **caractérisé en ce qu'**une roue à aubes (46) est capable de rotation dans la chambre de tourbillonnements (44).

5. Dispositif selon la revendication 4, **caractérisé en ce que** la pompe de recirculation (12) comprend une plaque de couverture pour la roue à aubes (46).

6. Dispositif selon la revendication 4 ou 5, **caractérisé en ce qu'**un écoulement traversant, qui est engendré au moyen de la roue à aubes (46), est amené à passer le long de l'élément de contact thermique (32 ; 80 ; 86 ; 90).

7. Dispositif selon l'une des revendications 4 à 6, **caractérisé en ce que** la roue à aubes (46) est agencée de manière à être tournée vers l'élément de contact thermique (32 ; 80 ; 86 ; 90).

8. Dispositif selon l'une des revendications précédentes, **caractérisé en ce que** l'élément de contact thermique (32) est produit en un matériau métallique.

9. Dispositif selon l'une des revendications précédentes, **caractérisé en ce que** l'élément de contact thermique (32) est réalisé sous forme de plaque.

10. Dispositif selon l'une des revendications précédentes, **caractérisé en ce que** la pompe de recirculation (12) est réalisée sous forme de pompe centrifuge.

11. Dispositif selon la revendication 10, **caractérisé en ce qu'**il est prévu un palier sphérique (58, 60) pour un rotor (42) de la pompe de recirculation (12).

12. Dispositif selon la revendication 10 ou 11, **caractérisé en ce que** la pompe de recirculation (12) comprend un moteur électrique (38) avec un stator (54) et un rotor (42), entre lesquels est formé un intervalle d'air sphérique (74).

13. Dispositif selon l'une des revendications 10 et 11, **caractérisé en ce que** la pompe de recirculation (12) est traversée coaxialement.

14. Dispositif selon l'une des revendications précédentes, **caractérisé en ce qu'**une conduite d'alimentation (20) pour un milieu liquide est couplée à un boîtier (18) de la pompe de recirculation (12) transversalement à un axe de rotation (40) d'un rotor (42) de la pompe de recirculation (12).

15. Dispositif selon l'une des revendications précédentes, **caractérisé en ce qu'**une conduite d'évacuation (26) pour un milieu liquide est couplée à un boîtier (18) de la pompe de recirculation (12) transversalement à un axe de rotation (40) d'un rotor (42) de la pompe de recirculation (12).

16. Dispositif selon l'une des revendications précédentes, **caractérisé en ce qu'**une conduite d'évacuation (26) pour un milieu liquide provenant de la pompe de recirculation (12), et une conduite d'alimentation (20) pour un milieu liquide destiné à la pompe de recirculation (12) sont couplés sur le même côté (43) d'un boîtier (18) de la pompe de recirculation (12).

17. Dispositif selon l'une des revendications précédentes, **caractérisé en ce que** l'élément de contact thermique (32 ; 80 ; 86 ; 90) est agencé sur le côté refoulement de la pompe de recirculation (12).

18. Dispositif selon l'une des revendications précédentes, **caractérisé en ce que** l'élément de contact thermique (32 ; 80 ; 86 ; 90) comporte des nervures sur sa face intérieure (78).

19. Dispositif selon la revendication 18, **caractérisé en ce que** les nervures sont ainsi réalisées qu'elles favorisent les turbulences.

20. Dispositif selon l'une des revendications précédentes, **caractérisé en ce que** des pales sont agencées sur le rotor (42) dans un intervalle d'air (74) entre un stator (54) et un rotor (42).

21. Dispositif selon l'une des revendications précédentes, **caractérisé en ce qu'**une chambre de tourbillonnements (44) de la pompe de recirculation (12) présente un volume variable.

22. Dispositif selon l'une des revendications précédentes, **caractérisé en ce que** l'élément de contact thermique est réalisé flexible et/ou mobile de telle façon qu'il est possible d'exercer une pression préalable sur le système.

23. Dispositif selon l'une des revendications précédentes, **caractérisé en ce que** l'élément de contact thermique est réalisé flexible et/ou mobile de telle façon qu'il est possible d'offrir un volume de dilatation pour le liquide.

24. Dispositif selon la revendication 22 ou 23, **caractérisé en ce qu'**une pression préalable peut être exercée sur le système au moyen d'un dispositif de fixation (92) pour la pompe de recirculation (12) sur l'objet (14).

25. Dispositif selon l'une des revendications précédentes, **caractérisé en ce que** la pompe de recirculation (12) est maintenue par rapport à l'objet (14) au moyen d'une ou plusieurs pinces de maintien (94).
